# FASCICULE DE BREVET EUROPEEN

(11) **EP 0 929 140 B1**
(45) Date de publication et mention de la délivrance du brevet: **01.10.2008**
(21) Numéro de dépôt: 98410154.3
(22) Date de dépôt: 31.12.1998
(51) Int. Cl.: H02H 9/04, H01L 27/02, H03K 17/0814

(54) **Protection d'un transistor MOS vertical associé à des cellules de mesure**
Schutz eines vertikalen, Messzellen zugeordneten MOS-Transistors
Protection of a vertical type MOS transistor associated with measuring cells

(30) Priorité: 31.12.1997 FR 9716868
(43) Date de publication de la demande: 14.07.1999
(73) Titulaire: STMicroelectronics S.A., 92120 Montrouge (FR)
(72) Inventeur: Bienvenu, Philippe, 13190 Allauch (FR)
(74) Mandataire: de Beaumont, Michel

(56) Documents cités:
- WO-A-89/08928
- US-A- 5 410 171
- US-A- 5 420 532

## Description

La présente invention concerne les transistors MOS verticaux de puissance et plus particulièrement la protection d'un transistor MOS vertical de puissance couplé à un transistor MOS vertical de mesure de courant.

Un transistor MOS vertical de puissance est généralement constitué d'un grand nombre de cellules élémentaires identiques en parallèle. Pour mesurer le courant dans ce transistor il est usuel de lui associer un transistor de mesure constitué d'un plus petit nombre des mêmes cellules élémentaires, soumises aux mêmes conditions de polarisation. Ceci est par exemple décrit dans les documents WO-A-89/08928 et US-A-5410171. Lorsque la charge du transistor de puissance est une charge inductive, une tension négative apparaît aux bornes de la charge lors de l'ouverture du transistor de puissance. Cette tension est susceptible de déclencher la conduction d'éléments parasites et d'endommager le transistor de puissance.

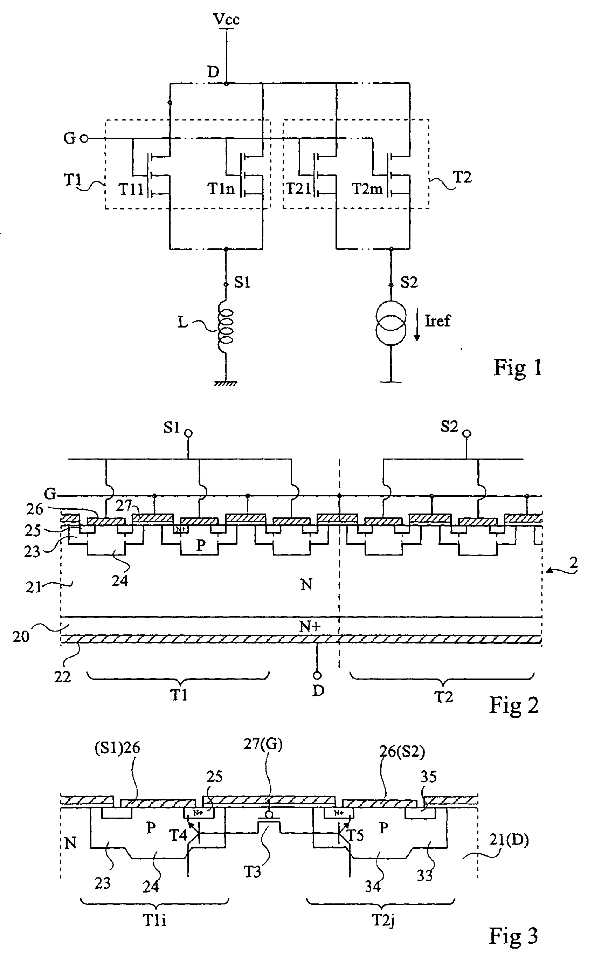

La figure 1 représente un circuit comportant un transistor MOS vertical de puissance T1 composé de n cellules élémentaires T11 à T1n, associé à un transistor MOS vertical de mesure T2 comprenant m cellules élémentaires T21 à T2m avec m très inférieur à n. Les drains D des cellules élémentaires du transistor de puissance et du transistor de mesure sont connectés ensemble à un potentiel but d'alimentation Vcc. Les grilles G des cellules élémentaires du transistor de puissance et du transistor de mesure sont connectées ensemble à une borne de commande G. Les sources S1 des cellules élémentaires du transistor de puissance sont interconnectées et reliées par une charge inductive L à la masse. Les sources S2 des cellules élémentaires du transistor de mesure sont interconnectées et reliées à une source de courant I_{ref}. La différence de tension entre les bornes S1 et S2 donne une indication du fait que le courant dans le transistor de puissance est supérieur ou inférieur à un seuil égal à (n/m)I_{ref}.

On remarquera que dans certaines applications, la source de courant Iref peut être remplacée par une résistance R, lorsque le circuit est destiné à mesurer une résistance de charge au lieu d'un courant de charge.

La figure 2 représente de manière schématique une vue en coupe verticale d'une partie d'une plaquette de silicium 2 dans laquelle sont réalisés les transistors T1 et T2. Le drain d'une cellule élémentaire correspond au substrat 21 de la plaquette. La zone 21 est connectée par l'intermédiaire d'une zone 20 fortement dopée de type N (N⁺) à une métallisation 22 reliée à la borne de drain D du circuit de la figure 1.

La source d'une cellule élémentaire correspond à un anneau 25 de type N⁺ formé dans un caisson 23 de type P. Le caisson 23 comprend généralement une zone centrale 24 fortement dopée de type P (P⁺). Une métallisation de source 26 est en contact avec la partie centrale de chaque caisson 23 et avec l'anneau 25.

La grille d'une cellule élémentaire est formée par une couche de silicium polycristallin 27, isolée de la surface de la plaquette par un diélectrique, qui recouvre une zone de canal comprise entre la périphérie externe de l'anneau 25 et la périphérie externe du caisson 23. Les grilles 27 sont interconnectées à un noeud de grille G.

On a représenté en figure 2 trois cellules élémentaires du transistor de puissance T1. Les métallisations 26 de ces cellules élémentaires sont connectées à un même noeud de source S1. De même, on a représenté deux cellules élémentaires du transistor de mesure T2, les métallisations 26 de ces cellules étant connectées à un même noeud de source S2.

La figure 3 représente à plus grande échelle une partie de la figure 2 sur laquelle on fait figurer des éléments parasites existant entre deux cellules élémentaires adjacentes. Classiquement, la grille 27 recouvre également la zone du substrat 21 comprise entre deux cellules élémentaires. Cette métallisation, isolée du substrat 21, correspond à une grille d'un transistor parasite T3 de type PMOS formé d'un caisson 23 de type P d'une première cellule élémentaire, d'une portion de substrat 21 de type N et d'un deuxième caisson 33 de type P d'une deuxième cellule élémentaire.

D'autre part, l'association d'une zone 25 de type N⁺, d'un caisson 23 de type P et du substrat 21 faiblement dopé de type N, forme un transistor parasite bipolaire de type NPN dont l'émetteur est la zone 25, le collecteur la zone 21 et la base le caisson 23.

On considère une cellule élémentaire T1i du transistor de puissance adjacente à une cellule élémentaire T2j du transistor de mesure, dont les sources sont respectivement S1 et S2. Un transistor bipolaire T4 de type NPN est connecté entre la source S1 et le drain D de la cellule du transistor T1. La base du transistor T4 est connectée au drain d'un transistor PMOS parasite T3. De même, un transistor bipolaire T5 de type NPN est connecté entre la source S2 et le drain D de la cellule du transistor T2, la base du transistor T5 est connectée à la source du transistor MOS T3. Le transistor MOS T3 est commandé par la grille G commune aux transistors T1 et T2.

Comme l'illustre la figure 1, si la charge L du transistor T1 est une charge inductive, la tension aux bornes de la charge, c'est-à-dire sur la source S1, va devenir négative lorsque le transistor de puissance sera ouvert. La grille G, qui correspond à la grille du transistor T3 est alors négative mais à une tension supérieure à la source S1, et la source S2 est à un potentiel voisin de la masse. Si la tension est très négative sur la source S1, le transistor MOS T3 qui est alors passant laisse passer un courant important entre les bornes S2 et S1. Quand ce courant, qui circule notamment sous la région N⁺ 25 dépasse un certain seuil, le transistor bipolaire T4 devient passant. Ceci crée un court-circuit entre les bornes de source 26 et de drain 22 de la cellule T2i. la borne 26 étant à un potentiel très négatif et la borne 22 au potentiel Vcc, il peut en résulter un claquage destructif de la structure. Le courant qui traverse le transistor T4 dépend du gain de ce transistor. Or, dans le cadre des technologies modernes, la taille des caissons 23 diminue et le niveau de dopage des zones 24 est réduit. Il en résulte que le gain des transistors bipolaires parasites T4 augmente et donc que le risque de claquage destructif augmente.

Les inventeurs ont donc recherché des moyens pour supprimer les effets destructifs liés à la mise en conduction des transistors bipolaires parasites par les transistors MOS parasites susmentionnés.

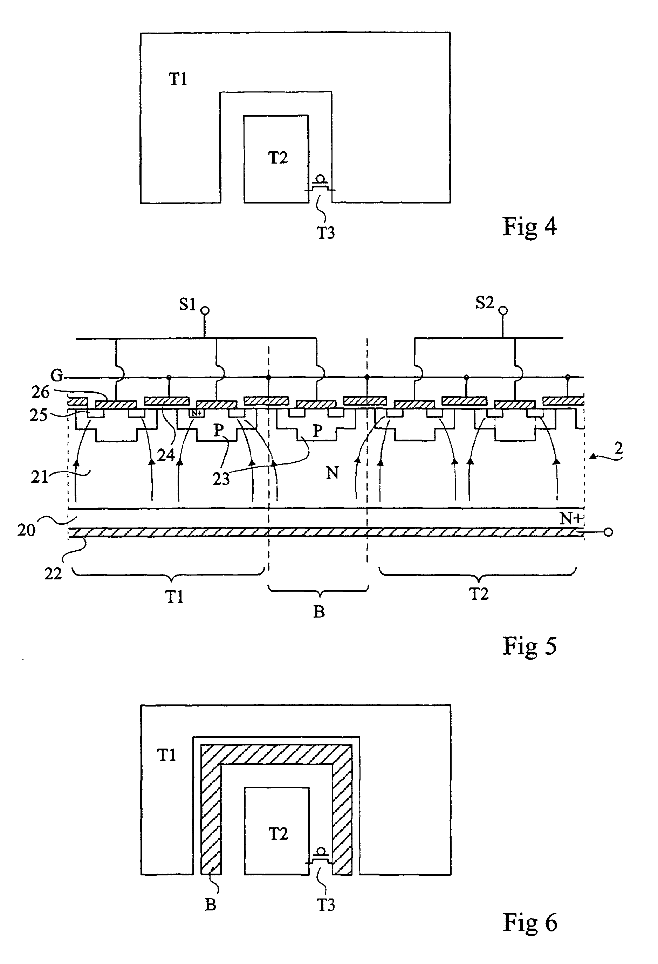

La figure 4 représente très schématiquement une vue de dessus d'un dispositif tel que celui représenté en figure 1. Le bloc T1 représente la surface occupée par les cellules élémentaires du transistor de puissance T1 et le bloc T2 représente la surface occupée par les cellules élémentaires du transistor de mesure T2. T3 symbolise les transistors MOS parasites existant entre les cellules adjacentes du transistor de puissance et du transistor de mesure.

La figure 5 représente une vue en coupe verticale d'une première solution pour éviter les claquages destructifs susmentionnés. La structure est très proche de la structure représentée en figure 2, et de mêmes références désignent de mêmes éléments. Entre deux cellules élémentaires adjacentes T1i et T2j appartenant respectivement au transistor de puissance et au transistor de mesure, est intercalée une cellule tampon B. On peut réaliser une telle cellule tampon en supprimant l'implantation N⁺ des sources dans une cellule élémentaire de T1. Il n'existe alors plus de transistors bipolaires parasites.

La figure 6 représente de manière extrêmement schématique une vue de dessus d'un dispositif tel que celui de la figure 5. Le bloc T1 représente la surface occupée par les cellules élémentaires du transistor de puissance T1, le bloc T2 représente la surface occupée par les cellules élémentaires du transistor de mesure T2, et le bloc B représente la surface occupée par les cellules tampons placées entre le transistor de puissance et le transistor de mesure. Le transistor T3 représente les transistors MOS parasites existant entre les cellules élémentaires du transistor de mesure T2 et les cellules tampons B adjacentes.

En figure 5, on a représenté par des flèches les courants passant en fonctionnement normal du drain vers la source de cellules élémentaires des transistors de puissance et de mesure. Les cellules élémentaires adjacentes aux cellules tampons B reçoivent en fonctionnement normal une plus forte densité de courant que les autres cellules élémentaires. Le rapport entre les courants traversant les transistors T1 et T2 varie avec la valeur des courants. Ce déséquilibre des courants ne permet plus de déterminer simplement le courant dans le transistor T1 de puissance à partir du courant traversant le transistor T2 de mesure.

Un objet de la présente invention est de réaliser la protection d'un dispositif tel que celui représenté en figure 1.

Un objet de la présente invention est de réaliser un dispositif comprenant un transistor de puissance et un transistor de mesure dans lequel il existe en fonctionnement normal un rapport constant entre le courant traversant le transistor de mesure et le courant traversant le transistor de puissance.

Un autre objet de la présente invention consiste à proposer une solution peut coûteuse et facile à mettre en oeuvre aux problèmes rencontrés dans l'art antérieur.

Ces objets ainsi que d'autres sont atteints par un dispositif de protection d'un composant monolithique comprenant un transistor de puissance de type MOS vertical diffusé composé d'un grand nombre de cellules identiques, et un transistor de mesure composé d'un plus faible nombre de cellules identiques à celles du transistor de puissance, les drains et les grilles de toutes les cellules étant communs, une charge inductive étant connectée à la source du transistor de puissance, et comprenant :
un moyen de mise en court-circuit connecté entre la source du transistor de puissance et la source du transistor de mesure, et
un moyen de commande susceptible de mettre en conduction ledit moyen de mise en court-circuit à l'ouverture du transistor de puissance.

Selon un mode de réalisation de la présente invention, le moyen de mise en court-circuit est un transistor MOS.

Selon un mode de réalisation de la présente invention, le moyen de commande est un pont diviseur connecté aux bornes de la charge inductive.

Selon un mode de réalisation de la présente invention, le moyen de commande consiste en une diode dont l'anode est connectée à la grille du transistor de mise en court-circuit et dont la cathode est connectée à la cathode d'une diode à avalanche, dont l'anode est connectée à la source du transistor de puissance, et une résistance connectée entre la grille du transistor de mise en court-circuit et la masse.

Selon un mode de réalisation de la présente invention, le substrat et la source du transistor de mise en court-circuit sont connectés l'un à l'autre.

Selon un mode de réalisation de la présente invention, le moyen de mise en court-circuit est un transistor latéral réalisé dans le même composant monolithique que les transistors verticaux de puissance et de mesure.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un dispositif selon l'art antérieur ;
la figure 2 représente une vue partielle en coupe du dispositif représenté en figure 1 ;
la figure 3 représente des composants parasites dans un détail de la figure 2 ;
la figure 4 représente très schématiquement une vue de dessus du mode de réalisation représenté en figure 1 ;
la figure 5 représente la vue en coupe d'un autre mode de réalisation selon l'art antérieur ;
la figure 6 représente très schématiquement une vue de dessus du mode de réalisation représenté en figure 5 ;
la figure 7 représente un schéma sous forme de blocs selon la présente invention ;
la figure 8 représente très schématiquement un mode de réalisation selon la présente invention ;
la figure 9 représente très schématiquement une vue en coupe du mode de réalisation représenté en figure 8 ;
la figure 10 représente très schématiquement une vue de dessus du mode de réalisation représenté en figure 8 ; et
la figure 11 représente très schématiquement un autre mode de réalisation selon la présente invention.

Dans les diverses figures, de mêmes références désignent de mêmes éléments. En outre, comme cela est classique dans le domaine de la représentation des composants semiconducteurs, les diverses vues en coupe et de dessus ne sont pas tracées à l'échelle.

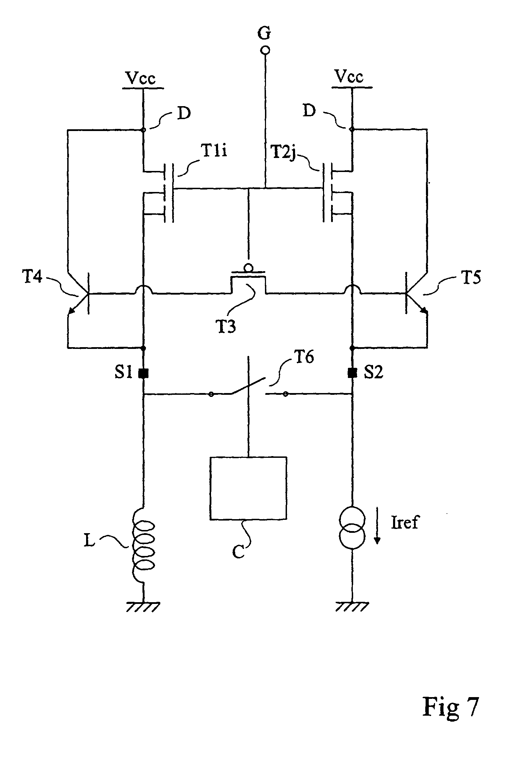

La figure 7 représente un schéma simplifié d'un circuit selon la présente invention. On a représenté une cellule T1i parmi les n cellules élémentaires T11 à T1n d'un transistor de puissance T1, et une cellule élémentaire T2j parmi les m cellules élémentaires T21 à T2m d'un transistor de mesure, la cellule T1i étant adjacente à la cellule T2j. Les drains des cellules élémentaires T1i et T2j sont connectés à une borne D commune à toutes les cellules, elle-même connectée à un potentiel haut d'alimentation Vcc. Les grilles G des cellules T1i et T2j sont connectées ensemble à une borne de commande G commune à toutes les cellules. La source de la cellule T1i est reliée à une borne S1 commune à toutes les cellules du transistor de puissance T1, elle-même reliée à la masse par une charge inductive L. La source de la cellule T2j est reliée à une borne S2 commune à toutes les cellules du transistor de mesure T2, elle-même reliée à une source de courant I_{ref}. Comme dans l'art antérieur, la différence de tension entre les bornes S1 et S2 donne une indication du fait que le courant dans le transistor de puissance est supérieur ou inférieur à un seuil égal à (n/m)I_{ref}. On remarquera que la figure 7 est très simplifiée, et qu'une résistance est classiquement mise en série avec la source de courant I_{ref}, par exemple pour limiter le courant dans T3 lorsqu'il conduit, et pour faire chuter la tension sur S2 lorsque S1 devient négatif. Ceci permet de limiter la tension V_{GS2} de T2 lorsque S1 et G deviennent négatifs et ainsi d'éviter un claquage de l'oxyde de grille de T2.

On a également représenté en figure 7 des transistors parasites qui sont associés aux cellules T1i et T2j. Un transistor parasite bipolaire T4 est connecté en parallèle sur la cellule T1i. Un transistor parasite bipolaire T5 est connecté en parallèle sur la cellule T2j. Les bases des transistors T4 et T5 sont respectivement reliées au drain et à la source d'un transistor MOS parasite T3. la grille du transistor MOS parasite T3 est reliée à la grille G du circuit. Ces éléments parasites sont tels que décrits en relation avec la figure 3.

Selon l'invention, un moyen de mise en court-circuit T6 est connecté entre les bornes communes de source S1 et S2. Le moyen de mise en court-circuit T6 est commandé par un moyen de commande C qui est susceptible de mettre le moyen T6 en conduction à l'ouverture du transistor de puissance T1.

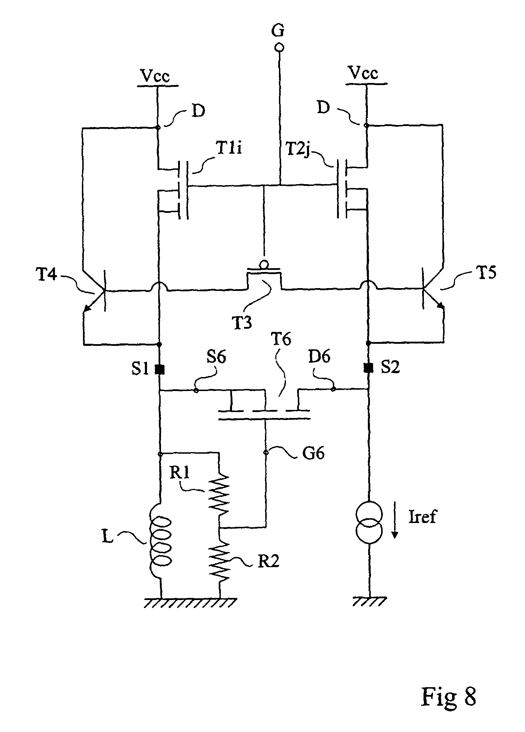

La figure 8 présente un mode de réalisation du moyen de mise en court-circuit T6 et du moyen de commande C. Le moyen de mise en court-circuit est un transistor MOS T6 dont la source S6 est connectée à la borne de source S1 et dont le drain D6 est connecté à la borne de source S2. Deux résistances R1 et R2 sont connectées en série aux bornes de la charge L, le point de connexion de ces deux résistances est connecté à la grille G6 du transistor T6.

Les résistances R1 et R2 forment un pont diviseur relié aux bornes de la charge L. Les résistances R1 et R2 sont choisies pour déclencher la conduction du transistor T6 lorsque le transistor de puissance T1 est ouvert, et que la tension aux bornes de la charge L dépasse un seuil négatif prédéterminé. Ce seuil négatif prédéterminé peut par exemple être choisi supérieur au seuil négatif pour lequel le courant traversant les éléments parasites susmentionnés est susceptible de déclencher le transistor parasite T4.

Quand il est mis en conduction, le transistor T6 court-circuite les bornes de source S1 et S2 du circuit et supprime tout risque de traversée du transistor MOS parasite T3 et donc de mise en conduction du transistor bipolaire parasite T4. On évite ainsi tout risque de claquage de la structure.

En mode de fonctionnement normal, la tension aux bornes de la charge L est telle que le transistor T6 reste bloqué, la présente invention n'affecte donc pas le fonctionnement en mode normal.

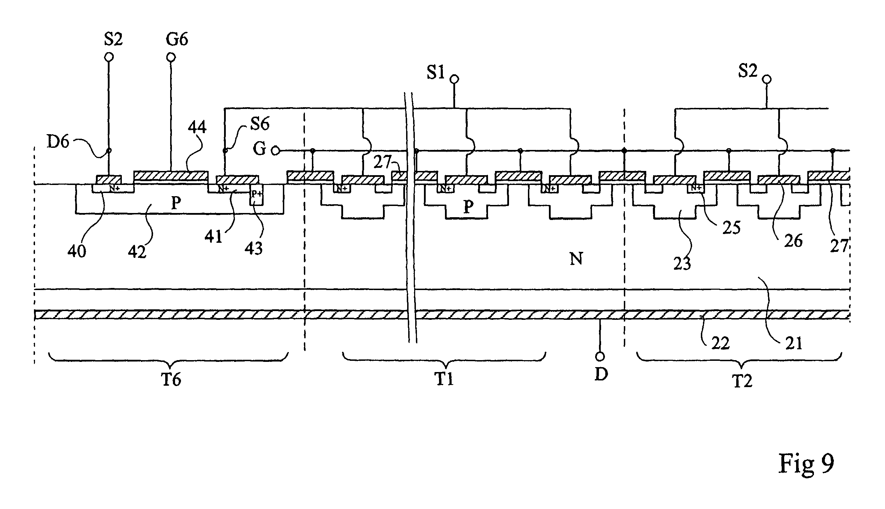

La figure 9 représente une vue en coupe simplifiée d'une partie du circuit selon la présente invention. La partie droite du circuit illustre des cellules de transistors MOS verticaux T1 et T2 décrites en relation avec la figure 2. En outre, dans la partie gauche de la figure 9, on a représenté une réalisation d'un transistor de mise en court-circuit T6, sous forme d'un transistor MOS de type latéral. Le drain du transistor T6 est constitué d'une zone fortement dopée 40 de type N⁺ formée dans un caisson dopé 42 de type P. Le drain D6 du transistor T6 est connecté à la borne de source S2 du transistor de mesure. La source du transistor T6 est constituée d'une zone fortement dopée 41 de type N⁺ formée dans le caisson 42. La source S6 du transistor T6 est connectée à la borne de source S1 du transistor de puissance. Le caisson 42 est polarisé par une zone 43 très dopée de type P⁺, également formée dans le caisson 42, et connectée à la borne S1. La grille G6 du transistor T6 est formée par une couche de silicium polycristallin 44 située au-dessus de la section du caisson 42 comprise entre les zones 40 et 41, isolée de la surface du caisson 42 par un diélectrique.

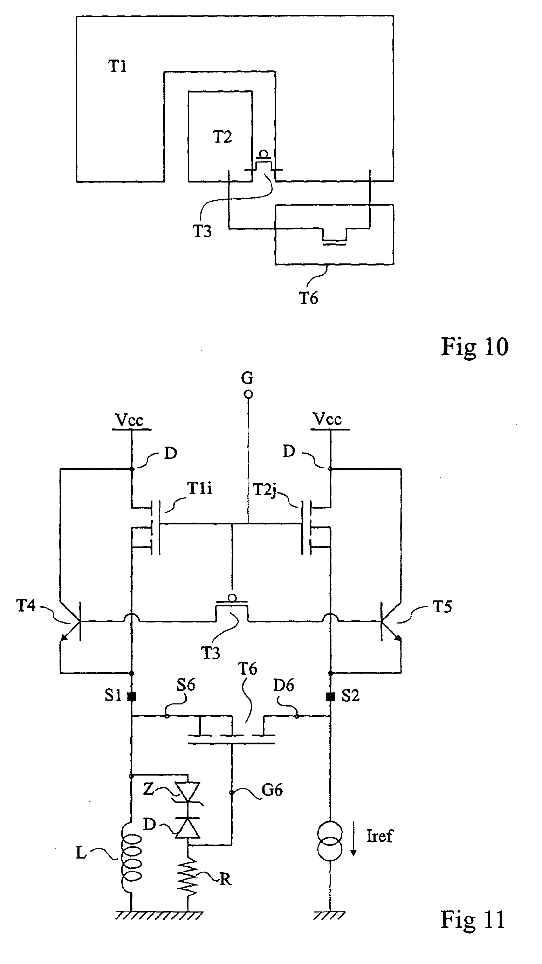

La figure 10 représente une vue de dessus simplifiée d'un circuit selon la présente invention. Le transistor T6 à été implanté au voisinage des transistors T1 et T2. Les tailles respectives des transistors T1, T2, T6 sont déterminées en fonction des courants maxima qui doivent les traverser.

Le transistor de mise en court-circuit T6 est, comme on l'a vu précédemment, bloqué en mode de fonctionnement normal. Le rapport entre les courants traversant le transistor de puissance T1 et le transistor de mesure T2 reste constant et déterminé (égal à n/m comme cela a été décrit en relation avec la figure 1). La présente invention permet ainsi de protéger le dispositif décrit dans l'art antérieur tout en conservant le même rapport entre courant de mesure et courant dans un transistor de puissance. L'ajout du transistor T6 est de surcroît peu coûteux et simple à mettre en oeuvre.

Bien entendu, la présente invention est susceptible de diverses variantes et modifications qui apparaîtront à l'homme de l'art par rapport à ce qui a été décrit en détail ci-dessus, tout en restant dans le domaine des revendications ci-après. Ainsi le moyen de mise en court-circuit T6 peut être réalisé par d'autres structures qu'un transistor MOS, par exemple un transistor bipolaire ou un thyristor. De même, le moyen de commande C peut être un pont diviseur, mais d'autres moyens de commande remplissant la même fonction pourront également être utilisés.

La figure 11 représente à titre d'exemple une variante du moyen de commande du transistor T6. Au lieu d'un pont diviseur résistif, on utilise ici un circuit comprenant une diode D, une diode à avalanche Z et une résistance R. L'anode de la diode D est reliée à une première borne d'une résistance R également reliée à la grille G6 du transistor T6, sa cathode est reliée à la cathode de la diode à avalanche Z. L'anode de la diode à avalanche Z est reliée à la borne de source S1. La seconde borne de la résistance R est reliée à la masse. La tension de conduction inverse de la diode à avalanche Z2 est choisie pour que le transistor T6 soit mis en conduction lorsque la tension en S1 devient plus négative qu'un seuil prédéterminé. Le moyen de commande formé par la diode à avalanche Z, la diode D et la résistance R consommera moins en mode de fonctionnement normal que le pont diviseur formé de la résistance R1 et de la résistance R2 représenté en figure 8.

## Revendications

1. Dispositif de protection d'un composant monolithique comprenant un transistor de puissance (T1) de type MOS vertical diffusé composé d'un grand nombre de cellules identiques (Tli), et un transistor de mesure (T2) composé d'un plus faible nombre de cellules (T2j) identiques à celles du transistor de puissance, les drains (D) et les grilles (G) de toutes les cellules étant communs, une charge inductive (L) étant connectée à la source (S1) du transistor de puissance, **caractérisé en ce qu'**il comprend :
un moyen (T6) de mise en court-circuit connecté entre la source (S1) du transistor de puissance et la source (S2) du transistor de mesure, et
un moyen de commande (C) susceptible de mettre en conduction ledit moyen de mise en court-circuit à l'ouverture du transistor de puissance.

2. Dispositif de protection selon la revendication 1, **caractérisé en ce que** le moyen de mise en court-circuit est un transistor MOS.

3. Dispositif de protection selon la revendication 1 ou 2, **caractérisé en ce que** le moyen de commande est un pont diviseur (R1, R2) connecté aux bornes de la charge inductive.

4. Dispositif de protection selon la revendication 1 ou 2, **caractérisé en ce que** le moyen de commande consiste en une diode (D) dont l'anode est connectée à la grille (G6) du transistor de mise en court-circuit et dont la cathode est connectée à la cathode d'une diode à avalanche (z), dont l'anode est connectée à la source du transistor de puissance, et une résistance (R) connectée entre la grille (G6) du transistor de mise en court-circuit et la masse.

5. Dispositif de protection selon l'une quelconque des revendications 2 à 4, **caractérisé en ce que** le substrat et la source du transistor de mise en court-circuit sont connectés l'un à l'autre.

6. Dispositif de protection selon la revendication 2, **caractérisé en ce que** le moyen de mise en court-circuit (T6) est un transistor latéral réalisé dans le même composant monolithique que les transistors verticaux de puissance (T1) et de mesure (T2).

## Claims

1. A protection device for a monolithic component comprising a diffused MOS-type vertical power transistor (T1) formed of a great number of identical cells (T1i), and a measurement transistor (T2) formed of a smaller number of cells (T2j) identical to those of the power transistor, the drains (D) and the gates (G) of all cells being common, an inductive load (L) being connected to the source (S1) of the power transistor, **characterized in that** it comprises:
a short-circuiting means (T6) connected between the source (S1) of the power transistor and the source (S2) of the measurement transistor, and
a control means (C) capable of turning on the short-circuiting means when the power transistor turns off.

2. The protection device of claim 1, **characterized in that** the short-circuiting means is a MOS transistor.

3. The protection device of claim 1 or 2, **characterized in that** the control means is a dividing bridge (R1, R2) connected across the inductive load.

4. The protection device of claim 1 or 2, **characterized in that** the control means consists in a diode (D), the anode of which is connected to the gate (G6) of the short-circuiting transistor and the cathode of which is connected to the cathode of an avalanche diode (Z), the anode of which is connected to the source of the power transistor, and a resistor (R) connected between the gate (G6) of the short-circuiting transistor and the ground.

5. The protection device of any of claims 2 to 4, **characterized in that** the substrate and the source of the short-circuiting transistor are interconnected.

6. The protection device of claim 2, **characterized in that** the short-circuiting means (T6) is a lateral transistor implemented in the same monolithic component as the vertical power (T1) and measurement (T2) transistors.

## Patentansprüche

1. Schutzvorrichtung für ein monolithisches Bauteil, das einen diffundierten vertikalen Leistungstransistor (T1) vom MOS-Typ aufweist, welcher aus einer großen Anzahl identischer Zellen (T1i) aufgebaut ist, und einen Messtransistor (T2) aufweist, der aus einer kleineren Anzahl von Zellen (T2j) aufgebaut ist, die identisch sind zu denen des Leistungstransistors, wobei die Drain- bzw. Kollektor-Anschlüsse (D) und die Gate- bzw. Basis-Anschlüsse (G) aller Zellen gemeinsam sind, wobei eine induktive Last (L) mit dem Source- bzw. Emitter-Anschluss (S1) des Leistungstransistors verbunden ist,
**dadurch gekennzeichnet, dass** die Schutzvorrichtung folgendes aufweist: Kurzschlussmittel (T6), die zwischen dem Source- bzw. Emitter-Anschluss (S1) des Leistungstransistors und Source- bzw. Emitter-Anschluss (S2) des Messtransistors verbunden sind, und
Steuermittel (C), die in der Lage sind, die Kurzschlussmittel ein- bzw. durchzuschalten, wenn der Leistungstransistor abschaltet bzw. öffnet.

2. Schutzvorrichtung gemäß Anspruch 1, **dadurch gekennzeichnet, dass** die Kurzschlussmittel ein MOS-Transistor sind.

3. Schutzvorrichtung gemäß Anspruch 1 oder 2, **dadurch gekennzeichnet, dass** die Steuermittel eine Teilerbrücke bzw. ein Spannungsteiler (R1, R2) sind, die bzw. der über die induktive Last hinweg verbunden ist.

4. Schutzvorrichtung gemäß Anspruch 1 oder 2, **dadurch gekennzeichnet, dass** die Steuermittel bestehen aus einer Diode (D), deren Anode mit dem Gate- bzw. Basis-Anschluss (G6) des Kurzschlusstransistors verbunden ist, und deren Kathode mit der Kathode einer Zener- bzw. Durchbruch-Diode (Z) verbunden ist, wobei die Anode der Zener- bzw. Durchbruch-Diode (Z) mit dem Source- bzw. Emitter-Anschluss des Leistungstransistors verbunden ist, und aus einem Widerstand (R), der zwischen dem Gate- bzw. Basis-Anschluss (G6) des Kurzschlusstransistors und Masse verbunden ist.

5. Schutzvorrichtung gemäß einem der Ansprüche 2 bis 4, **dadurch gekennzeichnet, dass** das Substrat und der Source- bzw. Emitter-Anschluss des Kurzschlusstransistors miteinander verbunden sind.

6. Schutzvorrichtung gemäß Anspruch 2, **dadurch gekennzeichnet, dass** die Kurzschlussmittel (T6) ein Lateraltransistor sind, welcher in dem gleichen monolithischen Bauteil implementiert ist wie der vertikale Leistungstransistor (T1) und der vertikaler Messtransistor (T2).
